Europäisches Patentamt

European Patent Office

Office européen des brevets

(19)

(11) Veröffentlichungsnummer: **0 104 593**

**A2**

# (12) EUROPÄISCHE PATENTANMELDUNG

(21) Anmeldenummer: 83109343.0

(22) Anmeldetag: 20.09.83

(51) Int. Cl.³: **H 01 J 37/28**

(30) Priorität: 27.09.82 DE 3235727

(43) Veröffentlichungstag der Anmeldung:
04.04.84 Patentblatt 84/14

(84) Benannte Vertragsstaaten:
DE GB NL

(71) Anmelder: SIEMENS AKTIENGESELLSCHAFT
Berlin und München Wittelsbacherplatz 2
D-8000 München 2(DE)

(72) Erfinder: Fazekas, Peter, Dipl.-Ing.
Stuntzstrasse 21
D-8000 München 80(DE)

(72) Erfinder: Otto, Johann, Dipl.-Ing.
Pater-Hammerschmid-Strasse 4
D-8170 Bad Tölz(DE)

(54) Verfahren zum Hervorheben eines Objektbereichs in einem Rastermikroskop.

(57) Ein Verfahren, bei dem während einer Objektabrasterung die Korpuskularsonde mit einer gegebenen Schrittweite ($\Delta x, \Delta y$) über das Objekt geführt wird und bei dem die Wiedergabe eines Bildes auf einem Bildaufzeichnungs-Gerät ebenfalls mit einer gegebenen Schrittweite erfolgt, soll das wesentlich raschere und zuverlässigere Finden eines interessierenden Objektbereichs als nach dem Stand der Technik ermöglichen. Dabei soll zugleich ein interessierender Objektausschnitt sowohl vergrößert als auch in seiner Einbettung innerhalb des zu untersuchenden Objekts betrachtet werden können. Die Schrittweite ($\Delta x, \Delta y$) der Korpuskularsonde und die Schrittweite bei der Bildaufzeichnung werden so aneinander angepaßt, daß auf dem Bildaufzeichnungs-Gerät mindestens ein Objektbereich in stärkerer Vergrößerung ($\beta$) als andere Objektbereiche erscheint.

FIG 2

SIEMENS AKTIENGESELLSCHAFT    Unser Zeichen
Berlin und München            VPA 82 P 1 8 7 8 E

Verfahren zum Hervorheben eines Objektbereichs in
einem Rastermikroskop.

Die Erfindung betrifft ein Verfahren zum Hervorheben
mindestens eines Objektbereichs in einem Rastermikroskop nach dem Oberbegriff des Anspruchs 1.

Während der Meßstellensuche bei der Überprüfung von
integrierten Schaltungen an einem Elektronenstrahl-Meßgerät ist es wegen der Regelmäßigkeit der Strukturen
innerhalb einer integrierten Schaltung günstig, wenn
man sich bei Betrachten kleiner Ausschnitte aus einer
solchen integrierten Schaltung immer wieder an Übersichtsaufnahmen von dieser integrierten Schaltung orientieren kann.

Bisher wurde dieses Problem bei marktüblichen rasterelektronenmikroskopischen Vorrichtungen dadurch gelöst, daß als Orientierungshilfe bei vielen marktüblichen rasterelektronenmikroskopischen Vorrichtungen
eine Möglichkeit angeboten wurde, ein Objekt in zwei verschiedenen Vergrößerungen wiederzugeben. Bei solchen
bekannten Vorrichtungen kann anhand eines Übersichtsbildes von einem zu untersuchenden Objekt mit Hilfe
eines Rahmens, der in dieses Übersichtsbild eingeblendet wird, der interessierende Objektausschnitt ausgewählt werden, der sodann herausvergrößert wird.

Der vorliegenden Erfindung liegt die Aufgabe zugrunde,
ein Verfahren der eingangs genannten Art anzugeben,

My 1 Bla / 20.9.1982

0104593

82 P 1878 E

bei dem ein interessierender Objektbereich wesentlich rascher und zuverlässiger gefunden werden kann als nach dem Stand der Technik möglich und bei dem zugleich ein interessierender Objektausschnitt sowohl vergrößert als auch in seiner Einbettung innerhalb des zu untersuchenden Objekts betrachtet werden kann.

Diese Aufgabe wird erfindungsgemäß durch ein Verfahren nach dem Anspruch 1 gelöst. Ausgestaltungen und Vorteile der Erfindung sind in den Unteransprüchen, der Beschreibung und der Zeichnung dargestellt.

Ein Ausführungsbeispiel der Erfindung wird im folgenden anhand der Zeichnung näher beschrieben.

Fig.1 erläutert ein erfindungsgemäßes Verfahren, bei dem die Elektronensonde mit einer variablen Schrittweite über ein Objekt geführt wird.

Fig.2 erläutert die unterschiedliche Vergrößerung des Objekts auf einem Bildschirm.

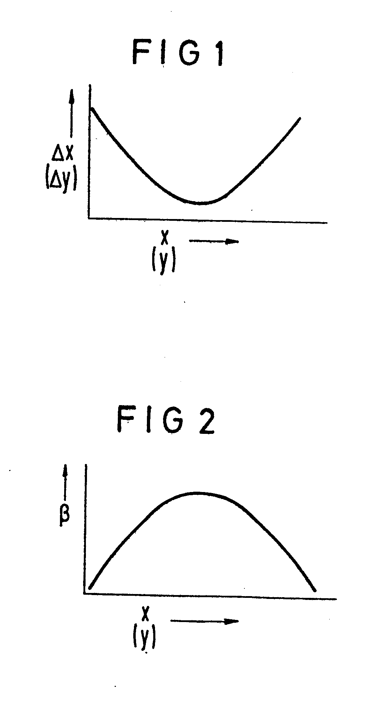

Während der Objektabrasterung wird die Elektronensonde von einem digitalen Rastergenerator in der x-y-Ebene über die Probe geführt. Dabei wird die Elektronensonde mit einer variablen Schrittweite $\Delta x$, $\Delta y$ über das Objekt geführt. Wie aus Fig.1 ersichtlich ist, wird über eine entsprechende Ansteuerung des digitalen Rastergenerators dafür gesorgt, daß sich diese variable Schrittweite $\Delta x$, $\Delta y$ während des Abrasterns in der x-y-Ebene vom Rand zur Mitte des Abtastfeldes hin sowohl in der x-Richtung als auch in der y-Richtung kontinuierlich verringert und in

0104593

82 P 1878 E

umgekehrter Weise von der Mitte des Abtastfeldes zum anderen Rand hin nach außen sich wieder kontinuierlich vergrößert. Dabei werden die Randbereiche des Abtastfeldes in der x-y-Ebene mit großer Schrittweite $\Delta$x, $\Delta$y, die Mitte des abzubildenden Abtastfeldes in der x-y-Ebene jedoch mit kleiner Schrittweite $\Delta$x, $\Delta$y abgetastet.

Fig.2 erläutert die Wiedergabe des mit einem Verfahren nach Fig.1 abgetasteten Abtastfeldes. Die Wiedergabe des Bildes erfolgt dabei auf einem Bildschirm, dessen Elektronenstrahl mit gleichbleibender Schrittweite über den Bildschirm gerastert wird. Auf diese Weise erscheint auf dem Sichtbildschirm das Objekt, das gemäß Fig.1 mit der Elektronensonde im Elektronenmikroskop abgerastert worden ist, in der Bildmitte in stärkerer Vergrößerung ß als am Bildrand. Da auf dem Bildschirm das abgetastete Objektfeld wiederum in einer x-y-Ebene wiedergegeben wird, ist die Vergrößerung ß des Objekts auf dem Bildschirmrand kleiner als in der Bildschirmmitte.

Durch diesen Lupeneffekt wird der interessierende Objektbereich stark herausvergrößert, während dennoch gleichzeitig auch die Umgebung und somit die Einbettung des interessierenden Objektbereichs in das Objekt auf dem Abtastfeld des Raster-Elektronenmikroskops dargestellt ist.

Erfindungswesentlich ist, daß ein interessierender Objektbereich vergrößert dargestellt werden kann und gleichzeitig seine Einbettung in die Umgebung kontrolliert werden kann. Ein solch unterschiedlich vergrößertes Bild auf einem Bildwiedergabe-Gerät kann auch dadurch erzielt werden, daß die Schrittweite, mit der die Elektronensonde über das Objekt geführt wird, konstant gehalten wird und die Schrittweite, mit der das Bild auf dem Bildwiedergabe-Gerät dargestellt wird, variabel gehandhabt wird.  Andererseits kann sowohl die Schrittweite, mit der die Elektronensonde über ein Objekt geführt wird, variabel gestaltet werden als auch die Schrittweite, mit der das Bild auf dem Bildwiedergabe-Gerät dargestellt wird, an die variable Schrittweite der Elektronensonde ebenfalls in variabler Weise so angepaßt werden, daß eine gewünschte unterschiedliche Vergrößerung des Objektbildes auf dem Bildwiedergabe-Gerät erzielt wird.

Patentansprüche:

1. Verfahren zum Hervorheben mindestens eines Objektbereichs in einem Rastermikroskop, bei dem während einer Objektabrasterung die Korpuskularsonde mit einer gegebenen Schrittweite ($\Delta$x, $\Delta$y) über das Objekt geführt wird und bei dem die Wiedergabe eines Bildes auf einem Bildaufzeichnungs-Gerät ebenfalls mit einer gegebenen Schrittweite erfolgt, dadurch g e k e n n - z e i c h n e t , daß die Schrittweite ($\Delta$x, $\Delta$y) der Korpuskularsonde und die Schrittweite bei der Bildaufzeichnung so aneinander angepaßt werden, daß auf dem Bildaufzeichnungs-Gerät mindestens ein Objektbereich in stärkerer Vergrößerung (ß) als andere Objektbereiche erscheint.

2. Verfahren nach Anspruch 1, dadurch g e k e n n - z e i c h n e t , daß die Korpuskularsonde mit variabler Schrittweite ($\Delta$x, $\Delta$y) über das Objekt geführt wird und die Wiedergabe des Bildes auf dem Bildaufzeichnungs-Gerät mit konstanter Schrittweite erfolgt.

3. Verfahren nach Anspruch 1, dadurch g e k e n n - z e i c h n e t , daß die Korpuskularsonde mit konstanter Schrittweite ($\Delta$x, $\Delta$y) über das Objekt geführt wird und die Wiedergabe des Bildes auf dem Bildaufzeichnungs-Gerät mit variabler Schrittweite erfolgt.

FIG 1

FIG 2